(19) 

**Europäisches Patentamt**
**European Patent Office**
**Office européen des brevets**

(11) **EP 4 317 542 A1**

(12) **EUROPEAN PATENT APPLICATION**
published in accordance with Art. 153(4) EPC

(43) Date of publication:
**07.02.2024  Bulletin 2024/06**

(21) Application number: **22779737.0**

(22) Date of filing: **28.02.2022**

(51) International Patent Classification (IPC):
***C30B 29/04*** (2006.01)    ***C01B 32/26*** (2017.01)
***C30B 11/00*** (2006.01)

(52) Cooperative Patent Classification (CPC):
**C01B 32/26; C30B 11/00; C30B 29/04**

(86) International application number:
**PCT/JP2022/008270**

(87) International publication number:
**WO 2022/209512 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  **31.03.2021  JP 2021061211**

(71) Applicant: **Sumitomo Electric Industries, Ltd.**
**Osaka-shi, Osaka 541 0041 (JP)**

(72) Inventors:
• **SUMIYA, Hitoshi**
**Osaka-shi, Osaka 541-0041 (JP)**

• **NISHIBAYASHI, Yoshiki**
**Osaka-shi, Osaka 541-0041 (JP)**
• **ZUO, Yikang**
**Osaka-shi, Osaka 541-0041 (JP)**
• **LEE, Jin Hwa**
**Osaka-shi, Osaka 541-0041 (JP)**
• **TERAMOTO, Minori**
**Osaka-shi, Osaka 541-0041 (JP)**
• **KOBAYASHI, Yutaka**
**Osaka-shi, Osaka 541-0041 (JP)**

(74) Representative: **Boult Wade Tennant LLP**
**Salisbury Square House**
**8 Salisbury Square**
**London EC4Y 8AP (GB)**

(54) **SINGLE CRYSTAL DIAMOND AND METHOD FOR PRODUCING SAME**

(57)    A single-crystal diamond, wherein the single-crystal diamond has an average of a phase difference per unit thickness of 10 nm/mm or less, and the phase difference has a standard deviation of 5 nm/mm or less.

EP 4 317 542 A1

**Description**

Technical Field

The present disclosure relates to a single-crystal diamond and a method of manufacturing the single-crystal diamond. The present application claims priority to Japanese Patent Application No. 2021-061211, filed March 31, 2021. The entire contents of this Japanese patent application are incorporated herein by reference.

Background Art

Diamonds have been used in various applications, such as heat sinks, wire-drawing dies, precision machining tools, optical components, laser windows, crystals for spectroscopy, monochromators, anvils for ultra-high pressure generators, and semiconductor diamond substrates. Among these applications, in particular, in the fields of optical components, laser windows, crystals for spectroscopy, monochromators, anvils for ultra-high pressure generators, and semiconductor diamond substrates, diamonds with fewer crystal defects and less distortion have been developed to improve performance (for example, Patent Literature 1 to Patent Literature 3).

Citation List

Patent Literature

PTL 1: Japanese Unexamined Patent Application Publication No. 7-116494
PTL 2: Japanese Unexamined Patent Application Publication No. 7-148426
PTL 3: Japanese Unexamined Patent Application Publication No. 9-165295

Summary of Invention

The present disclosure provides a single-crystal diamond, wherein

the single-crystal diamond has an average of a phase difference per unit thickness of 10 nm/mm or less, and
the phase difference has a standard deviation of 5 nm/mm or less.

The present disclosure provides a method of manufacturing the single-crystal diamond, the method including:

a first step of preparing a single-crystal diamond material with an average of a phase difference per unit thickness of 20 nm/mm or less and a standard deviation of the phase difference of 10 nm/mm or less;
a second step of cutting out a diamond seed crystal from the single-crystal diamond material; and
a third step of growing a diamond crystal on the diamond seed crystal by a temperature difference method to manufacture the single-crystal diamond.

Brief Description of Drawings

[Fig. 1] Figure 1 is a photograph substituted for a drawing of an example of a UV-excited emission image of a single-crystal diamond according to a first embodiment.
[Fig. 2] Figure 2 is a schematic view of a sample chamber used in a method of manufacturing a single-crystal diamond according to a second embodiment.

Description of Embodiments

[Problems to be Solved by Present Disclosure]

In recent years, crystals for next-generation spectroscopy in the synchrotron radiation region, ultraprecision cutting tools, and substrates for magnetic sensor synthesis have attracted attention as new applications of diamonds. In these applications, further reduction of crystal defects and distortion is desired to improve performance.

Accordingly, it is an object of the present disclosure to provide a single-crystal diamond with fewer crystal defects and less distortion.

[Advantageous Effects of Present Disclosure]

The present disclosure can provide a single-crystal diamond with fewer crystal defects and less distortion.

[Description of Embodiments of Present Disclosure]

First, embodiments of the present disclosure are described below.

(1) The present disclosure provides a single-crystal diamond, wherein

the single-crystal diamond has an average of a phase difference per unit thickness of 10 nm/mm or less, and
the phase difference has a standard deviation of 5 nm/mm or less.

A single-crystal diamond according to the present disclosure has fewer crystal defects and less distortion. Thus, a single-crystal diamond according to the present disclosure used as a crystal for next-generation spectroscopy has improved resolution. A single-crystal diamond according to the present disclosure used for an ultraprecision cutting tool improves the strength and fracture resistance of the tool. A single-crystal diamond according to the present disclosure can be used for a sensitive magnetic sensor material. In this case, a color center, such as a NV center formed by a nitrogen impurity remaining in a trace amount as an impurity in the single-crystal diamond and a vacancy and/or a SiV center formed by a silicon impurity and a vacancy, is used as a sensor. Alternatively, the color center is formed by implanting nitrogen, silicon, or the like into the diamond by ion implantation or the like and forming a vacancy, and is used as a sensor. This improves the sensitivity of a magnetic sensor. A single-crystal diamond according to the present disclosure used as a substrate for the synthesis of a sensitive magnetic sensor can be used to synthesize a sensitive diamond magnetic sensor with less distortion. A single-crystal diamond according to the present disclosure can be used as a substrate for CVD synthesis to synthesize a CVD diamond with less distortion. In the synthesis of the CVD diamond, various color centers can be formed as described above by implanting nitrogen, silicon, or the like by ion implantation or the like and forming a vacancy, thereby using the CVD diamond as a sensitive magnetic sensor material.

(2) Preferably, the single-crystal diamond has a nitrogen content based on the number of atoms of 0.1 ppm or less, and
the single-crystal diamond has a boron content based on the number of atoms of 0.1 ppm or less.

This further reduces crystal defects and distortion in the single-crystal diamond.

(3) Preferably, the single-crystal diamond has a dislocation density of $10^2$ /cm$^2$ or less, and
the dislocation density is measured in an etching test.

This provides a single-crystal diamond with high crystallinity.

(4) Preferably, the single-crystal diamond has a first region of 1 mm$^2$,

the first region has no defect, and
the presence or absence of the defect is determined in an X-ray topographic image of the single-crystal diamond.

This provides a single-crystal diamond with high crystallinity.

(5) Preferably, a Raman shift $\lambda 1$ cm$^{-1}$ of a peak in a first-order Raman scattering spectrum of the single-crystal diamond and a Raman shift $\lambda 2$ cm$^{-1}$ of a peak in a first-order Raman scattering spectrum of a synthetic IIa single-crystal diamond with a nitrogen content of 1 ppm or less have a relationship of the formula 1:

$$-0.002 \leq \lambda 1 - \lambda 2 \leq 0.002 \qquad \text{formula 1}$$

This further reduces the distortion of the single-crystal diamond.

(6) Preferably, the single-crystal diamond has a crack initiation load of 10 N or more. This provides the single-crystal diamond with high breaking strength and fracture resistance. For example, the single-crystal diamond used as a cutting tool can provide the cutting tool with high fracture resistance.

(7) Preferably, the single-crystal diamond has a vicinal growth trace. The vicinal growth trace originates from a boundary between different growth sectors in the single-crystal diamond. In the single-crystal diamond with higher crystallinity, the boundary is clearer, and the vicinal growth trace is easier to identify. Thus, the single-crystal diamond with a vicinal growth trace has high crystallinity. The vicinal growth trace is identified in a single-crystal diamond synthesized by a temperature difference method at high pressure and temperature. Thus, the single-crystal diamond with a vicinal growth trace is synthesized by the temperature difference method at high pressure and temperature. The single-crystal diamond synthesized by the temperature difference method at high pressure and temperature has much higher crystal growth stability, much fewer crystal defects, and much less residual distortion than single-crystal diamonds synthesized by a solubility difference method at high pressure and temperature (a film growth method) or by a gas-phase synthesis method (a CVD method). Thus, the single-crystal diamond synthesized by the temperature difference method has higher crystallinity than single-crystal diamonds synthesized by other methods, and among crystals synthesized by the temperature difference method, a crystal with higher crystallinity has a vicinal growth trace as described above.

(8) A method of manufacturing a single-crystal diamond according to the present disclosure is a method of manufacturing the single-crystal diamond described above, the method including:

a first step of preparing a single-crystal diamond material with an average of a phase difference per unit thickness of more than 10 nm/mm and 20 nm/mm or less and a standard deviation of the phase difference of more than 5 nm/mm and 10 nm/mm or less;
a second step of cutting out a diamond seed crystal from the single-crystal diamond material; and
a third step of growing a diamond crystal on the diamond seed crystal by a temperature difference method to manufacture the single-crystal diamond.

This can provide a single-crystal diamond with fewer crystal defects and less distortion.
(9) Preferably, the diamond seed crystal does not have a defect observed in an etching test. This reduces defects in the single-crystal diamond and further reduces the distortion of the single-crystal diamond.
(10) Preferably, the diamond seed crystal does not have a defect observed in an X-ray topographic image. This reduces defects in the single-crystal diamond and further reduces the distortion of the single-crystal diamond.
(11) Preferably, in the second step, the diamond seed crystal is cut out from a growth sector other than a {111} sector among growth sectors of the single-crystal diamond material.
This reduces defects in the diamond seed crystal. This reduces defects in the single-crystal diamond and further reduces the distortion of the single-crystal diamond.

[Details of Embodiments of Present Disclosure]

Specific examples of a single-crystal diamond according to the present disclosure and a method of manufacturing the single-crystal diamond are described below with reference to the accompanying drawings. In the present disclosure, like reference numerals denote like parts or equivalents thereof throughout the figures. For the sake of clarity and simplification of the drawings, the dimensions, such as length, width, thickness, and depth, are appropriately modified and do not necessarily represent actual dimensions.
The notation "A to B", as used herein, refers to the upper and lower limits of the range (that is, A or more and B or less). When the unit is not described in A but is described in B, the unit of A and the unit of B are the same.
In the crystallographic description herein, () indicates an individual plane, and { } indicates a group plane.

[First Embodiment: Single-Crystal Diamond]

A single-crystal diamond according to an embodiment of the present disclosure (hereinafter also referred to as "the present embodiment")

has an average of a phase difference per unit thickness of 10 nm/mm or less, and
the phase difference has a standard deviation of 5 nm/mm or less.

(Phase Difference)

A diamond is an isotropic crystal and typically has an isotropic refractive index (a dielectric constant). On the other hand, a diamond with a defect and distortion has a birefringence index. A defect in a diamond irradiated with circularly polarized light causes a phase difference and emits elliptically polarized light (including linearly polarized light). On the other hand, when irradiated with circularly polarized light, a portion other than defects causes no phase difference and emits the circularly polarized light. The optical axis and the phase difference can be determined by determining the directions of the major axis and the minor axis of the ellipse in elliptically polarized light and the ratio of the length of the major axis to the length of the minor axis. Furthermore, a lens and a microscope can be combined to acquire information on a local phase difference in a fine portion. Furthermore, polarizers integrated in front of pixels of a digital detector can be arranged to two-dimensionally acquire information in each pixel (that is, information at a local position of the sample). Such a principle is used to measure the value (nm/mm) of the phase difference per unit thickness of the single-crystal diamond.

The phase difference has a positive correlation with the number of defects and the magnitude of distortion in a single-crystal diamond. The single-crystal diamond according to the present embodiment has an average of a phase difference of 10 nm/mm or less, and the standard deviation of the phase difference is 5 nm/mm or less. Thus, the single-crystal diamond has fewer crystal defects and less distortion.

The upper limit of the average of the phase difference of the single-crystal diamond is 10 nm/mm or less, preferably 8 nm/mm or less, more preferably 6 nm/mm or less. The lower limit of the average of the phase difference of the single-crystal diamond is preferably 0 nm/mm. The average of the phase difference of the single-crystal diamond preferably ranges from 0 nm/mm to 10 nm/mm, preferably 0 nm/mm to 8 nm/mm, preferably 0 nm/mm to 6 nm/mm, preferably 0.1 nm to 10 nm, more preferably 0.2 nm/mm to 8 nm/mm, still more preferably 0.4 nm/mm to 6 nm/mm.

The upper limit of the standard deviation of the phase difference per unit thickness of the single-crystal diamond is 5 nm/mm or less, preferably 4 nm/mm or less, more preferably 3 nm/mm or less. The lower limit of the standard deviation of the phase difference of the single-crystal diamond is preferably 0 nm/mm. From the perspective of manufacture, the lower limit of the standard deviation of the phase difference can be, for example, 0.05 nm/mm or more. The standard deviation of the phase difference of the single-crystal diamond preferably ranges from 0 nm/mm to 5 nm/mm, preferably 0.05 nm/mm to 5 nm/mm, more preferably 0.05 nm/mm to 4 nm/mm, still more preferably 0.1 nm/mm to 3 nm/mm.

The phase difference per unit thickness of the single-crystal diamond is measured by the following procedure. First, the surface of the single-crystal diamond is polished and finished to a state in which no streaks due to damage at the time of polishing are seen with a phase-contrast microscope (a birefringence distribution measuring apparatus). The polishing method is a method capable of finish processing without damage, such as skeif polishing or glass polishing. It has been confirmed that polishing by this polishing method does not affect the original phase difference of a single-crystal diamond.

Next, the phase difference of a single-crystal diamond is measured with a birefringence distribution measuring apparatus ("WPA-micro" (trademark), "WPA-100" (trademark)), or "PA-300" (trademark) manufactured by Photonic Lattice, Inc.). A measurement region in a polished surface of a single-crystal diamond is irradiated with light in a direction perpendicular to the polished surface. The shape of the measurement region is made rectangular, circular, or polygonal by masking that matches to the polished surface to be measured. The shape of the measurement region is a rectangle with a side in the range of 1 mm to 10 mm, a circle with a diameter in the range of 1 mm to 10 mm, or a polygon (with an area in the range of 1 mm$^2$ to 100 mm$^2$) corresponding to the shape of the polished measurement surface. In this measurement region, the measurement is performed after confirming that no damage due to polishing is observed on the sample surface with a phase-contrast microscope (a birefringence distribution measuring apparatus). The measurement conditions include a measurement wavelength of 850 nm and 50 scans (high-precision measurement conditions). Although a phase difference of more than 90 degrees (1/4 of the wavelength) is usually difficult to discriminate, this birefringence distribution measuring apparatus uses an integrated wave plate system instead of an integrated polarizer system, and the measurement range is extended to a phase difference of 180 degrees (1/2 of the wavelength). It has been experimentally verified that the use of three wavelengths (one center wavelength and two wavelengths close to the center wavelength) extends the measurement range to five to six times the wavelength. The frequency distribution of the phase difference, the average of the phase difference, and the standard deviation of the phase difference in the measurement region are calculated by performing surface measurement of the measurement region with the birefringence distribution measuring apparatus and processing the measured values using software ("PA-View" (trademark) manufactured by Photonic Lattice, Inc.).

The value obtained by dividing the average of the phase difference (nm) in the measurement region by the thickness (mm) of the measurement sample corresponds to "the average of the phase difference per unit thickness (nm/mm) of a single-crystal diamond". The value obtained by dividing the standard deviation of the phase difference (nm) by the thickness (mm) of the measurement sample corresponds to "the standard deviation of the phase difference per unit thickness (nm/mm) of a single-crystal diamond".

It has been confirmed that the average value and the standard deviation of the phase difference do not vary even if the setting position in the measurement region in a single-crystal diamond is changed in the polished surface.

(Nitrogen Content and Boron Content)

The nitrogen content based on the number of atoms (hereinafter also referred to as the "nitrogen content") of the single-crystal diamond according to the present embodiment is preferably 0.1 ppm or less, and the boron content based on the number of atoms (hereinafter also referred to as the "boron content") of the single-crystal diamond is preferably 0.1 ppm or less. Nitrogen and boron in a single-crystal diamond cause a crystal defect and distortion. The single-crystal diamond according to the present embodiment with a nitrogen content and a boron content in the above ranges has further fewer crystal defects and less distortion.

The upper limit of the nitrogen content of the single-crystal diamond is preferably 0.1 ppm or less, more preferably 0.08 ppm or less, still more preferably 0.05 ppm or less, still more preferably 0.03 ppm or less. The lower limit of the nitrogen content of the single-crystal diamond is preferably 0 ppm or more. From the perspective of manufacture, the lower limit of the nitrogen content may be 0.000001 ppm or more. The nitrogen content of the single-crystal diamond preferably ranges from 0 ppm to 0.1 ppm, preferably 0.000001 ppm to 0.1 ppm, preferably 0.000001 ppm to 0.08 ppm, preferably 0.000001 ppm to 0.05 ppm, preferably 0.000001 ppm to 0.03 ppm, preferably 0.00001 ppm to 0.05 ppm, preferably 0.0001 ppm to 0.03 ppm.

The upper limit of the boron content of the single-crystal diamond is preferably 0.1 ppm or less, more preferably 0.05 ppm or less, still more preferably 0.01 ppm or less.

The lower limit of the boron content of the single-crystal diamond is preferably 0 ppm or more. From the perspective of manufacture, the lower limit of the boron content may be 0.000001 ppm or more. The boron content of the single-crystal diamond preferably ranges from 0 ppm to 0.1 ppm, preferably 0.000001 ppm to 0.1 ppm, preferably 0.000001 ppm to 0.05 ppm, preferably 0.000001 ppm to 0.01 ppm, preferably 0.00001 ppm to 0.05 ppm, preferably 0.0001 ppm to 0.01 ppm.

The nitrogen content of the single-crystal diamond preferably ranges from 0 ppm to 0.1 ppm, and the boron content of the single-crystal diamond preferably ranges from 0 ppm to 0.1 ppm. The nitrogen content of the single-crystal diamond more preferably ranges from 0.000001 ppm to 0.05 ppm, and the boron content of the single-crystal diamond more preferably ranges from 0.000001 ppm to 0.05 ppm. The nitrogen content of the single-crystal diamond still more preferably ranges from 0.00001 ppm to 0.03 ppm, and the boron content of the single-crystal diamond still more preferably ranges from 0.00001 ppm to 0.01 ppm.

The nitrogen content and the boron content of a single-crystal diamond is measured by secondary ion mass spectrometry (SIMS).

It has been confirmed that the nitrogen content and the boron content do not vary with the measurement point in a single-crystal diamond.

(Dislocation Density)

The single-crystal diamond according to the present embodiment has a dislocation density of $10^2$ /cm$^2$ or less, and the dislocation density is measured in an etching test. The term "dislocation density", as used herein, refers to a measure indicating the amount of dislocation derived from a needle-like defect linearly extending in a single-crystal diamond, and is measured in an etching test described later. More specifically, the dislocation density corresponds to the number of inverted-quadrangular-pyramid-shaped etch pits per unit area in an etching test described later. A needle-like defect causes lower crystallinity. The single-crystal diamond according to the present embodiment has a dislocation density of $10^2$ /cm$^2$ or less and has high crystallinity due to fewer needle-like defects.

The upper limit of the dislocation density of the single-crystal diamond is preferably $10^2$ /cm$^2$ or less, more preferably 10 /cm$^2$ or less, still more preferably 1 /cm$^2$ or less. The lower limit of the dislocation density of the single-crystal diamond is preferably 0 /cm$^2$ or more. From the perspective of manufacture, the lower limit of the dislocation density may be 1 /cm$^2$ or more. The single-crystal diamond preferably has a dislocation density in the range of 0 /cm$^2$ to $10^2$ /cm$^2$, more preferably 0 /cm$^2$ to 10 /cm$^2$, still more preferably 0 /cm$^2$ to 1 /cm$^2$.

The dislocation density of a single-crystal diamond is measured in an etching test. More specifically, it is measured by the following procedure.

A single-crystal diamond is immersed in a potassium nitrate (KNO$_3$) melt etchant and is heated in a platinum crucible at 600°C for 1 hour (etching). After slow cooling, the single-crystal diamond is taken out, and the surface is observed with an optical microscope at a magnification of 50 times. The number of point-like etch pits is counted in a 1000 $\mu$m x 1000 $\mu$m rectangular measurement region to obtain the number of point-like etch pits per mm$^2$. The term "point-like etch pit", as used herein, refers to a point-like depression in a single-crystal diamond surface. The depression is a tetragon, a tetragon with rounded corners, or an approximate circle on the (100) plane of a single-crystal diamond, or a triangle, a triangle with rounded corners, or an approximate circle on the (111) plane of the single-crystal diamond, and the distance across the depression ranges from approximately 1 $\mu$m to 50 $\mu$m. The number of point-like etch pits per cm$^2$ is calculated by multiplying the number of point-like etch pits per mm$^2$ by 100. In the present description, the number of point-like etch pits per cm$^2$ corresponds to the dislocation density. Linear etch pits as well as point-like etch pits may be observed on the surface of a single-crystal diamond after etching. The linear etch pits originate from stacking faults in a single-crystal diamond. In the measurement of the dislocation density, the number of linear etch pits is not counted.

In a single-crystal diamond, five measurement regions are determined. The average of the numbers of point-like etch pits per cm$^2$ in the five measurement regions is defined as "the dislocation density of the single-crystal diamond" in the present embodiment. It has been confirmed that the dislocation density does not vary even if the setting position in the measurement region in a single-crystal diamond is changed. The number of point-like etch pits in the same measurement region was counted by a plurality of different observers, and it has been confirmed that the same measurement results were obtained by all the observers. In other words, it has been confirmed that the measurement results do not vary depending on the observer.

(First Region)

Preferably, the single-crystal diamond according to the present embodiment includes a first region of 1 mm$^2$, the first region does not include a defect, and the presence or absence of defects is determined in an X-ray topographic image of the single-crystal diamond. A defect in a single-crystal diamond may be a point defect, such as a vacancy, a linearly extending needle-like defect, an impurity, a stacking fault, a distortion, or the like. Among these defects, a needle-like defect and a stacking fault can be identified in an X-ray topographic image. A portion of a needle-like defect or a stacking fault has higher X-ray reflection intensity than the rest of the crystal (a portion with fewer defects, that is, a portion with high crystallinity) and, in an X-ray topographic image, is indicated as a dark portion in a positive image and as a bright portion in a negative image. A single-crystal diamond without a defect observed in an X-ray topographic image has high crystallinity. The dark portion or the bright portion in an X-ray topographic image is visually observed. The presence or absence of defects in the same X-ray topographic image was determined by a plurality of different observers, and it has been confirmed that the same measurement results were obtained by all the observers. In other words, it has been confirmed that the measurement results do not vary depending on the observer.

An X-ray topographic image is captured by the following method. MoK$\alpha$1 radiation ($\lambda$ = 0.71 A) is used as an X-ray source, and an X-ray topographic image by diffraction of a (220) plane of a diamond crystal is captured with a Lang camera. To make the distribution state of defects easier to understand, a sample is preferably processed into a sheet with a thickness of approximately 0.5 mm. This processing is performed by cutting out a sheet with a laser processing machine and flattening the section by skeif polishing. Alternatively, the presence or absence of defects in a relatively thick sample can be determined without processing the sample into a sheet by placing a slit on the X-ray side and taking a topograph (limited projection topograph) using a diffraction line from only a limited layer inside the sample.

(Raman shift ($\lambda$1 - $\lambda$2))

The Raman shift $\lambda$1 (cm$^{-1}$) of a peak in a first-order Raman scattering spectrum of the single-crystal diamond according to the present embodiment and the Raman shift $\lambda$2 (cm$^{-1}$) of a peak in a first-order Raman scattering spectrum of a synthetic IIa single-crystal diamond with a nitrogen content of 1 ppm or less preferably have the relationship of the formula 1:

$$-0.002 \leq \lambda1 - \lambda2 \leq 0.002 \qquad \text{formula 1}$$

The state of internal stress in a single-crystal diamond is a measure of distortion. A lower internal stress results in a lower distortion. The state of internal stress in a single-crystal diamond can be evaluated by comparing the Raman shift $\lambda$1 (cm$^{-1}$) of a peak in a first-order Raman scattering spectrum of a single-crystal diamond with the Raman shift $\lambda$2 (cm$^{-1}$) of a peak in a first-order Raman scattering spectrum of a synthetic IIa single-crystal diamond with a nitrogen atom content of 1 ppm or less (hereinafter also referred to as a standard sample or a synthetic IIa single-crystal diamond). More specifically, the state of internal stress in a single-crystal diamond can be evaluated on the basis of the magnitude of the peak position shift represented by the difference between $\lambda$1 and $\lambda$2 ($\lambda$1 - $\lambda$2). The reason for that is described below.

The synthetic IIa single-crystal diamond used as a standard sample refers to a high-purity single-crystal diamond without a lattice defect or internal distortion synthesized by a temperature difference method at high temperature and pressure. For example, it is commercially available as a high-purity IIa single-crystal diamond manufactured by Sumitomo Electric Industries, Ltd. The synthetic IIa single-crystal diamond has a nitrogen atom content of 1 ppm or less, more specifically 0 ppm to 1 ppm, contains almost no nitrogen atoms, and therefore has no internal stress in the diamond crystal. The synthetic IIa single-crystal diamond has a sharp strong single peak in the first-order Raman scattering spectrum. Typically, the Raman shift of this peak appears in the range of 1332 cm$^{-1}$ to 1333 cm$^{-1}$. The value of the Raman shift varies with the environmental temperature at the time of measurement. In the present description, the Raman shift is a value measured at room temperature (20°C to 25°C).

When a diamond crystal has an isolated substitutional nitrogen atom, a Raman shift shifts to a lower frequency side than that of the synthetic IIa single-crystal diamond. At this time, tensile stress derived from the isolated substitutional nitrogen atom is generated in the diamond crystal. On the other hand, when a diamond crystal has no isolated substitutional nitrogen atom but has an aggregated nitrogen atom, a Raman shift shifts to a higher frequency side than that of the synthetic IIa single-crystal diamond. At this time, no tensile stress is generated or a compressive stress is generated in the diamond crystal.

Thus, the state of internal stress of the single-crystal diamond can be evaluated by comparing the Raman shift $\lambda 1$ (cm$^{-1}$) of the single-crystal diamond according to the present embodiment with the Raman shift $\lambda 2$ (cm$^{-1}$) of the synthetic IIa single-crystal diamond.

On the basis of the above findings, the present inventors have intensively studied the relationship between the magnitude of the peak position shift represented by the difference between $\lambda 1$ (cm$^{-1}$) and $\lambda 2$ (cm$^{-1}$) ($\lambda 1 - \lambda 2$) and the distortion of a single-crystal diamond, and have found that the distortion of the single-crystal diamond tends to decrease when ($\lambda 1 - \lambda 2$) has the relationship of the formula 1:

$$-0.002 \le \lambda 1 - \lambda 2 \le 0.002 \qquad \text{formula 1}$$

The ($\lambda 1 - \lambda 2$) preferably ranges from -0.002 to 0.002, more preferably -0.0015 to 0.0015, still more preferably -0.001 to 0.001, still more preferably -0.0005 to 0.0005.

The Raman shift $\lambda 1$ of a peak in a first-order Raman scattering spectrum of the single-crystal diamond according to the present embodiment is measured by the following procedure. First, a surface of a measurement sample, that is, a single-crystal diamond is polished with a metal bonded grinding wheel to a surface roughness Ra of 20 nm or less. The measurement sample is typically and preferably close to square or octagonal. The polished surface is irradiated with a laser under the following conditions, and scattered Raman lines are detected.

(Measurement Conditions)

Measuring apparatus: LabRAM HR-800 (manufactured by HORIBA Jobin Yvon)

Laser wavelength: 532 nm

Measurement temperature: room temperature (20°C to 25°C)

Laser irradiation position (measurement region): A Raman line is detected at the following five positions (i) to (v):

(i) A Raman line is detected at the central portion of the polished surface of the measurement sample (at the position of the center of gravity in a two-dimensional plane).
(ii) A straight line is drawn from the central portion to an end portion of the polished surface, and a position P at which the straight line has the maximum length is specified. When the distance from the central portion to P is D1, a Raman line is detected at a position where the distance from the central portion is (3/4)D1 on the line segment from the central portion to P.
(iii) A straight line is drawn from the central portion in the direction opposite to P, and an intersection point Q between the straight line and the end portion of the polished surface is specified. Thus, P, the central portion, and Q are on a straight line L1. When the distance from the central portion to Q is D2, a Raman line is detected at a position where the distance from the central portion is (3/4)D2 on the line segment from the central portion to Q.
(iv) A straight line L2 passing through the central portion and perpendicular to the straight line L1 passing through P, the central portion, and Q is drawn, and intersection points R and S between the straight line L2 and the end portion of the polished surface are specified. When the distance from the central portion to R is D3, a Raman line is detected at a position where the distance from the central portion is (3/4)D3 on the line segment from the central portion to R.
(v) When the distance from the central portion to S is D4, a Raman line is detected at a position where the distance from the central portion is (3/4)D4 on the line segment from the central portion to S.

A spectrum analysis is performed on the Raman lines detected at the five positions to measure the Raman shift of a peak in a first-order Raman scattering spectrum of the single-crystal diamond according to the present embodiment. The Raman shift is a wave number at which a first-order Raman scattering spectrum signal becomes the strongest. The peak shape is evaluated by peak fitting using a Lorentz function or a Gaussian function. Among the Raman shifts at the five positions, the Raman shift at the central portion and the Raman shifts at the other four positions are weighted-averaged at a ratio of 4:1. In the present description, the weighted average corresponds to the Raman shift $\lambda 1$.

In a single-crystal diamond, the crystallinity, such as distortion, of a sample can be uniquely evaluated and compared among samples by the setting of the measurement regions at the five positions and by the calculation method of the weighted average thereof.

The Raman shift $\lambda 2$ of a peak in a first-order Raman scattering spectrum of a high-purity synthetic IIa single-crystal diamond, which is a standard sample, is also measured in the same manner as the Raman shift $\lambda$1.

$\lambda$1 and $\lambda$2 are wave numbers at which a first-order Raman scattering spectrum signal becomes the strongest. The peak shape is evaluated by peak fitting using a Lorentz function or a Gaussian function. The temperature change of a detector and an optical system of a Raman spectrometer during measurement of a sample and a standard sample is controlled to $\pm$1°C or less.

The value of ($\lambda$1 - $\lambda$2) can be calculated to determine the peak position shift.

It has been confirmed that the measured values of the shift ($\lambda$1 - $\lambda$2) of a Raman spectrum do not vary even if the setting position in the measurement region in a single-crystal diamond is changed.

(Crack Initiation Load)

The crack initiation load of the single-crystal diamond according to the present embodiment is preferably 10 N or more. This provides the single-crystal diamond with high breaking strength and fracture resistance.

The lower limit of the crack initiation load of the single-crystal diamond is preferably 10 N or more, more preferably 12 N or more, still more preferably 15 Nor more. The upper limit of the crack initiation load is preferably, but not limited to, 50 N or less from the perspective of manufacture. The single-crystal diamond preferably has a crack initiation load in the range of 10 N to 50 N, more preferably 12 N to 50 N, still more preferably 15 N to 50 N.

The crack initiation load of a single-crystal diamond is measured by the following procedure. A spherical diamond indenter with a tip radius (R) of 50 $\mu$m is pressed against the (100) plane of a single-crystal diamond. In this state, a load is applied to the single-crystal diamond at a loading rate of 100 N/min, and the load at the moment of crack initiation in the single-crystal diamond (crack initiation load) is measured. The moment of crack initiation is measured with an AE sensor. The measurement temperature is 25°C. A larger crack initiation load indicates that the sample has higher strength and fracture resistance. When an indenter with a tip radius (R) of less than 50 $\mu$m is used as a measuring indenter, the sample is plastically deformed before crack initiation, and accurate strength against cracking cannot be measured. An indenter with a tip radius (R) of more than 50 $\mu$m may be used for the measurement but causes the problems of an increased load required for crack initiation, an increased contact area between the indenter and the sample, a significant influence of the surface accuracy of the sample on the accuracy of measurement, a significant influence of the crystal orientation of a single crystal, and the like. Thus, in a breaking strength test of a synthetic single-crystal diamond, an indenter with a tip radius (R) of 50 $\mu$m is preferably used.

(Vicinal Growth Trace)

The single-crystal diamond preferably has a vicinal growth trace. A single-crystal diamond with a vicinal growth trace has high crystallinity. A single-crystal diamond with a vicinal growth trace is synthesized by a temperature difference method at high pressure and temperature. Further optimizing the synthesis conditions while reducing crystal defects and distortion in the temperature difference method allows a vicinal growth trace to be observed in the synthesized single-crystal diamond. A single-crystal diamond synthesized by a CVD method has low crystallinity and does not have a vicinal growth trace.

In the present description, the presence or absence of a vicinal growth trace in a single-crystal diamond is determined in a UV (with a wavelength of 200 nm or less) excited emission image of the single-crystal diamond. More specifically, it is determined by the following procedure.

A single-crystal diamond is processed into a sheet parallel to (100) by laser processing or polishing. This is irradiated with ultraviolet radiation having a wavelength of 200 nm, and the resulting fluorescence distribution image is captured.

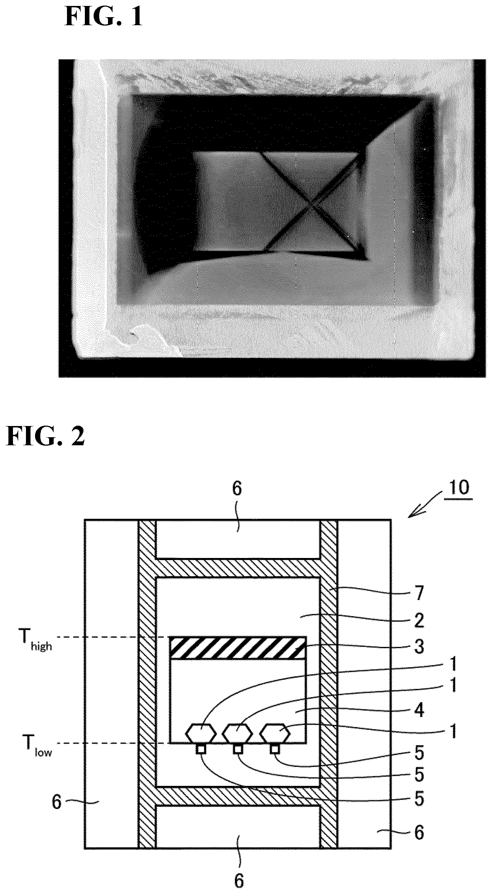

Fig. 1 shows an example of a UV-excited emission image of the single-crystal diamond according to the present embodiment. Fig. 1 is a UV-excited emission image captured by irradiating the single-crystal diamond with ultraviolet radiation in a direction perpendicular to the (100) plane of the single-crystal diamond. In Fig. 1, an X-shaped line is observed at the central portion of the single-crystal diamond. The X-shaped line corresponds to a vicinal growth trace.

(Applications)

The single-crystal diamond according to the present embodiment can be used in known applications, such as optical components, laser windows, crystals for spectroscopy, monochromators, anvils for ultra-high pressure generators, and semiconductor diamond substrates. The single-crystal diamond according to the present embodiment, which has fewer crystal defects and less distortion, can be suitable for use in new applications, such as crystals for next-generation spectroscopy in the synchrotron radiation region, ultraprecision cutting tools, magnetic sensor materials, and substrates for magnetic sensor synthesis.

[Second Embodiment: Method of Manufacturing Single-Crystal Diamond]

A method of manufacturing the single-crystal diamond according to the present embodiment is a method of manufacturing the single-crystal diamond according to the first embodiment, the method including:

a first step of preparing a single-crystal diamond material with an average of a phase difference per unit thickness of more than 10 nm/mm and 20 nm/mm or less and a standard deviation of the phase difference of more than 5 nm/mm and 10 nm/mm or less;
a second step of cutting out a diamond seed crystal from the single-crystal diamond material; and
a third step of growing a diamond crystal on the diamond seed crystal by a temperature difference method to manufacture the single-crystal diamond.

(First Step)

First, a single-crystal diamond material with an average of a phase difference per unit thickness of more than 10 nm/mm and 20 nm/mm or less and a standard deviation of the phase difference of more than 5 nm/mm and 10 nm/mm or less is prepared. The phase difference of the single-crystal diamond material is measured by the same method as the method of measuring the phase difference described in the first embodiment. Thus, in the following second step, it is possible to manufacture a diamond seed crystal with less distortion in which the average of the phase difference per unit thickness is more than 10 nm/mm and 20 nm/mm or less and the standard deviation of the phase difference is more than 5 nm/mm and 10 nm/mm or less.

The single-crystal diamond material can be a single-crystal diamond synthesized by a temperature difference method. The conditions of the temperature difference method are, for example, as follows: the solvent metal composition is Fe/Co = 10/90 to 90/10 (mass ratio), 1.5% by mass to 3% by mass of Ti or Al is added as a nitrogen getter to the solvent metal, the temperature gradient is adjusted such that the temperature difference between carbon and a seed crystal ranges from 10°C to 25°C, and a pressure in the range of 5.0 GPa to 5.5 GPa and a temperature in the range of 1300°C to 1350°C are held for 80 hours to 250 hours. A temperature difference of more than 25°C tends to result in irregular crystal growth and no vicinal growth trace. A temperature difference of less than 10°C results in a long time to grow a crystal of a predetermined size and causes a problem in manufacturing costs. The temperature change during holding is controlled within ±3°C. This further improves the crystallinity. A temperature change of more than ±3°C results in unstable growth, the occurrence of crystal defects, distortion, contamination of inclusions, and the like, and lower crystallinity. These conditions are not employed in the known temperature difference method.

(Second Step)

Next, a diamond seed crystal is cut out from the single-crystal diamond material. To cut out a diamond seed crystal, preferably, a sheet with a thickness in the range of approximately 0.3 to 0.5 mm is cut out by laser processing, the section is polished to a mirror surface, and a sheet with a size in the range of approximately 0.5 mm x 0.5 mm x 0.3 mm to 1.0 mm x 1.0 mm x 0.5 mm is then cut out by laser cutting. This can reduce the cutting margin and provide a seed crystal with a seed surface with less damage. Preferably, the seed surface of the diamond seed crystal is tetragonal or octagonal and has a size (the length of the opposite side) in the range of 0.3 mm to 3 mm.

The diamond seed crystal preferably does not have a defect observed in an etching test. For example, before a diamond seed crystal is cut out from a single-crystal diamond material, preferably, the single-crystal diamond material is subjected to an etching test to specify a region without defects, from which the diamond seed crystal is cut out. The etching test is performed under the same conditions as the etching test described in the first embodiment. Due to the diamond seed crystal without defects, this reduces defects in the single-crystal diamond and further reduces the distortion of the single-crystal diamond.

The diamond seed crystal preferably does not have a defect observed in an X-ray topographic image. For example, before a diamond seed crystal is cut out from a single-crystal diamond material, preferably, an X-ray topographic image of the single-crystal diamond material is taken to specify a region without defects in the X-ray topographic image, and the diamond seed crystal is cut out from the region. The X-ray topographic image is taken by the method described in the first embodiment. Due to the diamond seed crystal without defects, this reduces defects in the single-crystal diamond and further reduces the distortion of the single-crystal diamond.

In a single-crystal diamond material synthesized by a temperature difference method, a growth sector other than the {111} sector, such as a {001} sector, a {113} sector, a {115} sector, a {110} sector, or a {13 5} sector, has fewer defects, and the {111} sector has more defects. The term "{abc} sector", as used herein, refers to a region in which {abc} planes overlap and grow. More specifically, the {001} sector refers to a region in which the {001} planes overlap and grow. Thus, in the second step, cutting out a diamond seed crystal from a portion other than the {111} sector of a single-crystal diamond material reduces defects in the diamond seed crystal, reduces defects in the resulting single-crystal diamond, and further reduces the distortion of the single-crystal diamond. A growth sector other than the {111} sector of a single-crystal diamond material is, for example, the {001} sector, the {113} sector, the {115} sector, the {110} sector, the {135} sector, or a sector which can exist crystallographically. When a diamond seed crystal is cut out from a single-crystal diamond material, as long as the {111} sector is not included, the diamond seed crystal may be cut out from one sector other than the {111} sector or may be cut out so as to include two or more sectors.

In a single-crystal diamond material, the region of each sector can be specified in an emission image by ultraviolet radiation (a UV-excited emission image).

(Third Step)

Next, a diamond crystal is grown on the diamond seed crystal by a temperature difference method to manufacture a single-crystal diamond. This can provide a single-crystal diamond with fewer crystal defects and less distortion.

The temperature difference method in the third step is performed, for example, in a sample chamber with the structure illustrated in Fig. 2.

As illustrated in Fig. 2, a sample chamber 10 used to manufacture a single-crystal diamond 1 includes an insulator 2, a carbon source 3, a solvent metal 4, and a diamond seed crystal 5 in a space surrounded by a graphite heater 7, and includes a pressure medium 6 outside the graphite heater 7. The temperature difference method is a synthesis method of providing a vertical temperature gradient in the sample chamber 10, placing the carbon source 3 in a high-temperature portion ($T_{high}$), placing the diamond seed crystal 5 in a low-temperature portion ($T_{low}$), placing the solvent metal 4 between the carbon source 3 and the diamond seed crystal 5, and growing the single-crystal diamond 1 on the diamond seed crystal 5 at a temperature not lower than the temperature at which the solvent metal 4 melts and at a pressure not lower than the pressure at which the diamond is thermally stable.

The carbon source 3 is preferably a diamond powder. Graphite or pyrolytic carbon may also be used. The solvent metal 4 may be one or more metals selected from iron (Fe), cobalt (Co), nickel (Ni), manganese (Mn), and the like, or an alloy containing these metals. However, Ni and Mn are preferably not used because a trace amount of Ni or Mn may be incorporated into diamond depending on synthesis conditions. The amount of impurity boron in the carbon source and in the solvent metal is preferably controlled to 1 ppm or less. Thus, the boron content based on the number of atoms of the single-crystal diamond can be 0.1 ppm or less.

Titanium (Ti) is preferably added as a nitrogen getter to the solvent metal 4 at a concentration in the range of 1.5% by mass to 3% by mass. This can control the nitrogen content based on the number of atoms of the single-crystal diamond to be 0.1 ppm or less. Aluminum (Al) may be added as a nitrogen getter. In this case, an Fe-Al alloy may be used as a solvent.

The conditions of the temperature difference method are, for example, as follows: the temperature gradient is adjusted such that the temperature difference between carbon and a seed crystal ranges from 10°C to 25°C, and a pressure in the range of 5.0 GPa to 5.5 GPa and a temperature in the range of 1300°C to 1350°C are held for 80 hours to 300 hours. A temperature difference of more than 25°C often results in slightly irregular crystal growth and no vicinal growth. The temperature change during holding is controlled within ±3°C to further improve the crystallinity. These conditions are not employed in the known temperature difference method.

EXAMPLES

The present embodiment is more specifically described with reference to examples. However, the present embodiment is not limited by these examples.

<Manufacture of Single-Crystal Diamond>

A single-crystal diamond material manufactured by a temperature difference method was prepared. The "Average phase difference" and the "standard deviation of the phase difference" of a single-crystal diamond material used in each sample are shown in "Average" and "Deviation" columns of "Phase difference (nm/mm)" in Table 1.

[Table 1]

| Sample No. | Single-crystal diamond material | | | Diamond seed crystal | | Temperature difference method | | | |
|---|---|---|---|---|---|---|---|---|---|
| | Phase difference (nm/mm) | | Seed crystal cutting sector | Presence or absence of defects | | Pressure | Temperature | Temperature difference | Holding time |
| | Average | Deviation | | Etching test | X-ray topographic image | (GPa) | (°C) | (°C) | (h) |
| 1 | 13.6 | 7.7 | (100) | Absent | Absent | 5.3 | 1320 | 23 | 180 |
| 2 | 15.0 | 8.0 | (100)+(111) | Absent | Present (partly stacking fault) | 5.3 | 1350 | 23 | 180 |
| 3 | 17.7 | 7.5 | (100)+(111) | Absent | Present (partly stacking fault) | 5.3 | 1300 | 23 | 180 |
| 4 | 14.4 | 7.4 | (100) | Absent | Absent | 5.3 | 1320 | 23 | 180 |
| 5 | 12.5 | 5.1 | (100) | Absent | Absent | 5.3 | 1320 | 23 | 180 |
| 6 | 19.9 | 6.8 | (100) | Absent | Absent | 5.3 | 1320 | 23 | 180 |
| 1-1 | 47.6 | 17.8 | (100) | Present | Present (dislocation defect) | 5.3 | 1320 | 23 | 180 |
| 1-2 | 90.3 | 44.6 | (100)+(111) | Present | Present (dislocation defect + stacking fault) | 5.3 | 1320 | 23 | 180 |
| 1-3 | 26.4 | 12.4 | (111) | Present | Present (dislocation defect + stacking fault) | 5.3 | 1320 | 23 | 180 |
| 1-4 | 26.0 | 10.8 | (100)+(111) | Absent | Present (partly stacking fault) | 5.5 | 1300 | 30 | 180 |

Next, a diamond seed crystal with a size of 0.75 mm x 0.75 mm x 0.5 mm is cut out from the single-crystal diamond material using a laser processing machine. The diamond seed crystal is cut out from a sector described in the column of "Seed crystal cutting sector" of "Single-crystal diamond material" in Table 1 of the single-crystal diamond material. In this column, "(100)" means cutting out from the (100) sector. Furthermore, "(100) + (111)" means cutting out so as to include the (100) sector and the (111) sector. The presence or absence of defects in the diamond seed crystal was determined in an etching test and in an X-ray topographic image. The results are shown in the columns of "Etching test" and "X-ray topographic image" of "Presence or absence of defects" of "Diamond seed crystal" in Table 1.

Next, a diamond crystal is grown on the diamond seed crystal by the temperature difference method to manufacture a single-crystal diamond of each sample. The temperature difference method is performed in a sample chamber with the structure illustrated in Fig. 2. A diamond powder containing 100 to 200 ppm of nitrogen and 0.5 to 1 ppm of boron as impurities is used as a carbon source. High-purity Fe and Co are used as solvent metals, and the solvent composition is Fe:Co = 55:45 by mass ratio. 1.75% by mass of Ti is added to the solvent metals. The conditions of the temperature difference method in each sample are as follows: the temperature difference between a high-temperature portion (carbon source) and a low-temperature portion (seed crystal) is 23°C, the pressure is 5.3 GPa, and the holding temperature of the low-temperature portion is 1325°C. The holding time is 180 hours, and the temperature change during holding is controlled within ±3°C.

<Evaluation>

The single-crystal diamond of each sample was measured or confirmed with respect to the average of the phase difference per unit thickness, the standard deviation of the phase difference, the nitrogen content, the boron content, the dislocation density measured in the etching test, the presence or absence of defects identified in an X-ray topographic image, $\lambda 1 - \lambda 2$, the crack initiation load, and the presence or absence of a vicinal growth trace. A specific measurement or confirmation method of each item is described in the first embodiment. The results are shown in the columns of "Average", "Deviation", "N", "B", "Dislocation density", "Defect", "$\lambda 1 - \lambda 2$", "Crack initiation load", and "Vicinal growth trace" of "Phase difference" in Table 2.

[Table 2]

| Sample No. | Phase difference (nm/mm) | | N | B | Dislocation density | Defect | $\lambda 1 - \lambda 2$ | Crack initiation load | Vicinal growth trace |
|---|---|---|---|---|---|---|---|---|---|
| | Avarage | Deviation | (ppm) | (ppm) | (/cm$^2$) | Present/absent | (cm$^{-1}$) | (N) | Present/absent |
| 1 | 1.5 | 0.9 | 0.05 | 0.01 | 0 | Absent | 0.0005 | 22 | Present |
| 2 | 4.8 | 2.8 | 0.03 | 0.005 | 25 | Present | 0.001 | 17 | Present |
| 3 | 2.3 | 1.5 | 0.08 | 0.02 | 50 | Present | -0.0015 | 16 | Absent |
| 4 | 1.7 | 1.0 | 0.06 | 0.01 | 0 | Absent | 0.0003 | 19 | Present |
| 5 | 1.2 | 1.0 | 0.05 | 0.01 | 0 | Absent | 0.0012 | 23 | Present |
| 6 | 8.6 | 4.1 | 0.05 | 0.01 | 70 | Present | 0.001 | 12 | Absent |
| 1-1 | 14.1 | 7.1 | 0.05 | 0.01 | 160 | Present | -0.005 | 12 | Absent |
| 1-2 | 26.4 | 11.4 | 0.05 | 0.01 | 250 | Present | 0.003 | 9 | Absent |
| 1-3 | 36.5 | 24.1 | 0.05 | 0.01 | 430 | Present | 0.005 | 8 | Absent |
| 1-4 | 23.6 | 10.0 | 0.10 | 0.03 | 125 | Present | -0.003 | 15 | Absent |

EP 4 317 542 A1

<Discussion>

The manufacturing methods of Samples 1 to 6 correspond to examples. It has been confirmed that the single-crystal diamonds of Samples 1 to 6 manufactured by these manufacturing methods have an average of a phase difference per unit thickness of 10 nm/mm or less and a standard deviation of the phase difference of 5 nm/mm or less, correspond to examples, and have fewer crystal defects and less distortion.

The manufacturing methods of Samples 1-1 to 1-4 correspond to comparative examples. The single-crystal diamonds manufactured by these manufacturing methods have an average of a phase difference per unit thickness of more than 10 nm/mm and a standard deviation of the phase difference of more than 5 nm/mm, which correspond to comparative examples, and it has been confirmed that crystal defects and distortion are larger than those of the examples.

Although the embodiments and examples of the present disclosure have been described above, appropriate combinations and various modifications of the constituents of the embodiments and examples are also originally envisaged.

It is to be understood that the embodiments and examples disclosed above are illustrated by way of example and not by way of limitation in all respects. The scope of the present invention is defined by the appended claims rather than by the embodiments and examples described above. All modifications that fall within the scope of the claims and the equivalents thereof are therefore intended to be embraced by the claims. Reference Signs List

1 single-crystal diamond
2 insulator
3 carbon source
4 solvent metal
5 diamond seed crystal
6 pressure medium
7 graphite heater
10 sample chamber

**Claims**

1. A single-crystal diamond, wherein

   the single-crystal diamond has an average of a phase difference per unit thickness of 10 nm/mm or less, and
   the phase difference has a standard deviation of 5 nm/mm or less.

2. The single-crystal diamond according to claim 1, wherein

   the single-crystal diamond has a nitrogen content based on the number of atoms of 0.1 ppm or less, and
   the single-crystal diamond has a boron content based on the number of atoms of 0.1 ppm or less.

3. The single-crystal diamond according to claim 1 or 2, wherein

   the single-crystal diamond has a dislocation density of $10^2$ /cm$^2$ or less, and
   the dislocation density is measured in an etching test.

4. The single-crystal diamond according to any one of claims 1 to 3, wherein

   the single-crystal diamond has a first region of 1 mm$^2$,
   wherein the first region has no defect, and
   the presence or absence of the defect is determined in an X-ray topographic image of the single-crystal diamond.

5. The single-crystal diamond according to any one of claims 1 to 4, wherein
   a Raman shift $\lambda 1$ cm$^{-1}$ of a peak in a first-order Raman scattering spectrum of the single-crystal diamond and a Raman shift $\lambda 2$ cm$^{-1}$ of a peak in a first-order Raman scattering spectrum of a synthetic IIa single-crystal diamond with a nitrogen content of 1 ppm or less have a relationship of the following formula 1.

$$-0.002 \le \lambda 1 - \lambda 2 \le 0.002 \qquad \text{formula 1}$$

**6.** The single-crystal diamond according to any one of claims 1 to 5, wherein the single-crystal diamond has a crack initiation load of 10 N or more.

**7.** The single-crystal diamond according to any one of claims 1 to 6, wherein the single-crystal diamond has a vicinal growth trace.

**8.** A method of manufacturing the single-crystal diamond according to any one of claims 1 to 7, the method comprising:

a first step of preparing a single-crystal diamond material with an average of a phase difference per unit thickness of more than 10 nm/mm and 20 nm/mm or less and a standard deviation of the phase difference of more than 5 nm/mm and 10 nm/mm or less;
a second step of cutting out a diamond seed crystal from the single-crystal diamond material; and
a third step of growing a diamond crystal on the diamond seed crystal by a temperature difference method to manufacture the single-crystal diamond.

**9.** The method of manufacturing the single-crystal diamond according to claim 8, wherein the diamond seed crystal does not have a defect observed in an etching test.

**10.** The method of manufacturing the single-crystal diamond according to claim 8 or 9, wherein the diamond seed crystal does not have a defect observed in an X-ray topographic image.

**11.** The method of manufacturing the single-crystal diamond according to any one of claims 8 to 10, wherein in the second step, the diamond seed crystal is cut out from a growth sector other than a {111} sector among growth sectors of the single-crystal diamond material.

## FIG. 1

## FIG. 2

## INTERNATIONAL SEARCH REPORT

| International application No. |
|---|
| **PCT/JP2022/008270** |

**A. CLASSIFICATION OF SUBJECT MATTER**

*C30B 29/04*(2006.01)i; *C01B 32/26*(2017.01)i; *C30B 11/00*(2006.01)i
FI: C30B29/04 W; C30B11/00 Z; C30B29/04 U; C01B32/26

According to International Patent Classification (IPC) or to both national classification and IPC

**B. FIELDS SEARCHED**

Minimum documentation searched (classification system followed by classification symbols)

C30B29/04; C01B32/26; C30B11/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | JP 09-165295 A (SUMITOMO ELECTRIC IND., LTD.) 24 June 1997 (1997-06-24) paragraphs [0017]-[0037] | 1-11 |
| X | JP 2014-148463 A (SUMITOMO ELECTRIC IND., LTD.) 21 August 2014 (2014-08-21) paragraphs [0010]-[0015], [0029]-[0031] | 1-7 |
| A | | 8-11 |
| A | WO 2014/168053 A1 (SUMITOMO ELECTRIC IND., LTD.) 16 October 2014 (2014-10-16) entire text | 1-11 |
| A | WO 2019/077844 A1 (SUMITOMO ELECTRIC IND., LTD.) 25 April 2019 (2019-04-25) entire text | 1-11 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **14 April 2022** | **26 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/008270**

| Patent document cited in search report | | | Publication date (day/month/year) | Patent family member(s) | | | Publication date (day/month/year) |
|---|---|---|---|---|---|---|---|
| JP | 09-165295 | A | 24 June 1997 | US | 5908503 | A | |
| | | | | specification, column 7, line 8 to column 15, line 7 | | | |
| | | | | EP | 715885 | A2 | |
| JP | 2014-148463 | A | 21 August 2014 | US | 2006/0231015 | A1 | |
| | | | | examples, tables 1, 2 | | | |
| | | | | WO | 2006/048957 | A1 | |
| | | | | EP | 1712661 | A1 | |
| | | | | CN | 1865534 | A | |
| WO | 2014/168053 | A1 | 16 October 2014 | US | 2015/0191850 | A1 | |
| | | | | entire text | | | |
| | | | | EP | 2985368 | A1 | |
| | | | | CN | 104603335 | A | |
| WO | 2019/077844 | A1 | 25 April 2019 | US | 2020/0283927 | A1 | |
| | | | | entire text | | | |
| | | | | EP | 3699330 | A1 | |
| | | | | CN | 111247276 | A | |
| | | | | KR | 10-2020-0072482 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021061211 A
- JP 7116494 A
- JP 7148426 A
- JP 9165295 A